# EUROPEAN PATENT SPECIFICATION

(11) **EP 4 239 832 B1**
(45) Date of publication and mention of the grant of the patent: **02.12.2026**
(21) Application number: 22305249.9
(22) Date of filing: 04.03.2022
(51) Int. Cl.: H02J 7/54, H02J 7/80, H02J 7/96

(54) **APPARATUS AND METHOD FOR BALANCING VOLTAGE OF CELLS WITHIN A BATTERY PACK**
VORRICHTUNG UND VERFAHREN ZUM AUSGLEICH DER SPANNUNG VON BATTERIEZELLEN EINES BATTERIEPACKS
APPAREIL ET PROCÉDÉ POUR ÉQUILIBRER LA TENSION D'ÉLÉMENTS DE BATTERIE DANS UN BLOC-BATTERIE

(43) Date of publication of application: 06.09.2023
(73) Proprietor: NXP USA, Inc., Austin TX 78735 (US)
(72) Inventor: Paul, Carl-Hinrich, 5656 AG Eindhoven (NL); Dietsch, Jérôme, 31023 Toulouse Cedex 1 (FR); Steinfatt, Ole, 5656 AG Eindhoven (NL)
(74) Representative: Schmütz, Christian Klaus Johannes

(56) References cited:
- DE-U1- 20 107 438
- JP-A- H0 819 188
- US-A- 5 998 967
- US-A1- 2011 122 660
- US-A1- 2013 278 218

## Description

### TECHNICAL FIELD

The present disclosure relates to an apparatus, a system and a method for controlling a charge of a battery pack.

### BACKGROUND

In recent years, the use of batteries has become more and more widespread. A battery is also referred to as a battery pack. For example, battery packs are used as energy storage devices for electric vehicles. A battery pack has a plurality of battery modules, each comprising at least one battery cell. Usually, each battery module comprises a plurality of battery cells. The battery cells may be connected in series and in parallel. For example, the electrical voltage provided by the battery module may be determined by a string of battery cells of the battery module connected in series, wherein the battery module may comprise a plurality of such strings, which are connected in parallel. The battery cells of a battery module may also be arranged in a different structure. The battery modules of the battery pack are often connected in series, such that the electrical voltage provided by the battery pack is formed from the sum of the electrical voltages of the battery modules.

In principle, it is desirable that the battery cells of the battery pack are identical. In practice, however, there may be small variations in the amount of charge that can be stored by the battery cells and the electrical voltages provided by the battery cells. After several charge and discharge cycles of the battery pack, there may be differences in the amount of charge stored by the battery cells and in the electrical voltages provided by the battery cells. These differences can affect the performance of the battery pack and the lifetime of the battery pack.

To equalize the differences between the battery module electrical voltages (and stored amounts of charge), methods are known to equalize the battery module electrical voltages. This is also referred to as balancing of a battery modules Among the known methods, a distinction is made between active balancing and passive balancing. In passive balancing of the battery modules, the battery modules whose electrical voltage is increased are monitored and discharged to some degree so that a state of equilibrium is established with respect to the electrical voltages of the battery modules. Often, at least the battery modules with the increased electrical voltage are discharged to such an extent that their respective provided voltage corresponds to a predetermined value. The aim is that all battery modules provide the same electrical voltage except for a predetermined, (very) small deviation. The document US5 998 967 discloses an apparatus for controlling a charge of a battery pack having a plurality of battery modules connected in series, and comprising: a driver interface for coupling with a resistor unit, a driver unit connected to the driver interface, and a control unit, wherein the driver interface is configured to be connected to the battery pack via the resistor unit, and wherein the driver unit comprises a plurality of drivers each configured to regulate the electrical charge of a battery module according to a PWM control signal.

### SUMMARY

Aspects of the disclosure are defined in the accompanying claims.

In accordance with a first aspect of the present disclosure, an apparatus for controlling a charge of a battery pack having a plurality of battery modules connected in series is provided as defined by the independent claim 1. Among others, the apparatus comprises a driver interface for coupling with a resistor unit, a driver unit connected to the driver interface, and a control unit, wherein the driver interface is configured to be connected to the battery pack via the resistor unit, wherein the driver unit comprises a plurality of drivers each configured to regulate the electrical charge of a battery module according to a pulse width modulated, PWM, control signal, wherein the control unit is coupled to each driver, wherein the control unit is configured to generate for each driver an associated PWM control signal for individual control of the drivers, and wherein the control unit is configured to transmit to each driver the associated PWM control signal, so that an electrical charge of the battery modules can be controlled individually by the control unit via the PWM control signals.

In one or more embodiments, the apparatus additionally comprises: a sensor interface for coupling with the battery pack, and a sensor unit connected to the sensor interface, wherein the sensor unit is configured to detect module voltages of the battery modules based on signals of and/or from the battery pack representing electrical potentials at the battery pack, wherein the control unit is configured to generate for each driver the associated PWM control signal based on the module voltage of the respective battery module.

In one or more embodiments, each driver is configured to change between an active state and a deactivated state according to the PWM control signal for the respective driver, wherein each driver is configured to reduce the charge of a battery module in the active state and to leave the charge of the battery module unchanged in the deactivated state.

In one or more embodiments, each driver is configured to change between the active state and the deactivated state in accordance with a turn-on time, a turn-off time or a duty cycle of the PWM control signal for the respective driver.

In one or more embodiments, the control unit is configured to determine drivers to be activated based on the detected module voltages of the battery modules.

In one or more embodiments, the control unit is configured to generate for each driver to be activated the associated PWM control signal such that the driver generates a predetermined average discharge current for reducing the electrical charge of the associated battery module.

In one or more embodiments, the sensor unit is configured to update the detected module voltages of the battery modules continuously or by repeated sampling, and wherein the control unit is configured to control the average discharge current for a battery module by continuous or repeated adjustment of the PWM control signal based on the updated module voltage of the battery module such that the average discharge current is constant.

In one or more embodiments, the control unit is configured to control the average discharge current for a battery module by continuous or repeated adjustment of a turn-on time, a turn-off time, or a duty cycle of the PWM control signal based on the updated module voltage of the battery module such that the average discharge current is constant.

In one or more embodiments, the control unit stores control data which maps module voltages to turn-on times, turn-off times and/or duty cycles, and wherein the control unit is configured to also use the control data for each generation of a PWM control signal.

In one or more embodiments, the control unit stores a predetermined mapping algorithm which, when executed by the control unit, maps module voltages to turn-on times, turn-off times and/or duty cycles, and wherein the control unit is configured to also execute the mapping algorithm for each generation of a PWM control signal.

The drivers of the driver unit are grouped into a first group of drivers and a second group of drivers, wherein the control unit is configured to generate the PWM control signals such that all control signals are based on a common PWM cycle having a constant time duration for each period of the PWM cycle, and wherein the control unit is configured to activate only the drivers of the first group in a first part of each period and to activate only the drivers of the second group in a second part of each period.

In accordance with a second aspect of the present disclosure, a system for controlling the charge of a battery pack having a plurality of battery modules connected in series is provided. Each battery module includes at least one battery cell, wherein the system comprising: the apparatus, a resistor unit with several electrical load resistors, and a system interface for coupling with the battery pack, wherein the system interface is electrically connected to the driver interface of the apparatus via the resistor unit, such that the load resistors each provide electrical resistance between the driver interface and the system interface.

In one or more embodiments, the sensor interface is connected to or formed by the system interface.

In accordance with a third aspect of the present disclosure, a method for an apparatus for controlling the charge of a battery pack comprising a plurality of battery modules connected in series is provided as defined by the independent claim 13.

In one or more embodiments, the apparatus comprises a sensor interface for coupling to the battery pack and a sensor unit connected to the sensor interface, wherein the method may further comprise the following steps a1) to a3), which replace step a):
a1) Detecting of the module voltages of the battery modules by the sensor unit based on a signal from the battery pack representing electrical potentials at the battery pack,
a2) Determining the drivers to be activated by the control unit depending on the module voltages of the battery modules,
a3) Generating for each driver to be activated the associated PWM control signal by the control unit such that the respective driver generates a predetermined constant average discharge current for reducing the electrical charge of the associated battery module.

In accordance with a fourth aspect of the present disclosure, a computer program is provided, comprising executable instructions which, when executed by a processing unit, cause the processing unit being configured to carry out the method of the third aspect and/or one or more embodiments thereof.

### DESCRIPTION OF DRAWINGS

Embodiments of the present disclosure will be described in more detail with reference to the appended drawings, in which:
Figure 1 shows a block diagram of an embodiment of the system 126.
Figure 2 shows a block diagram of another embodiment of the system 126.
Figure 3 shows a block diagram of another embodiment of the system 126.
Figure 4 shows a block diagram of another embodiment of the system 126.
Figure 5 depicts a simplified flow chart of an embodiment of the method.
Figure 6 depicts a simplified flow chart of another embodiment of the method.

### DESCRIPTION OF EMBODIMENTS

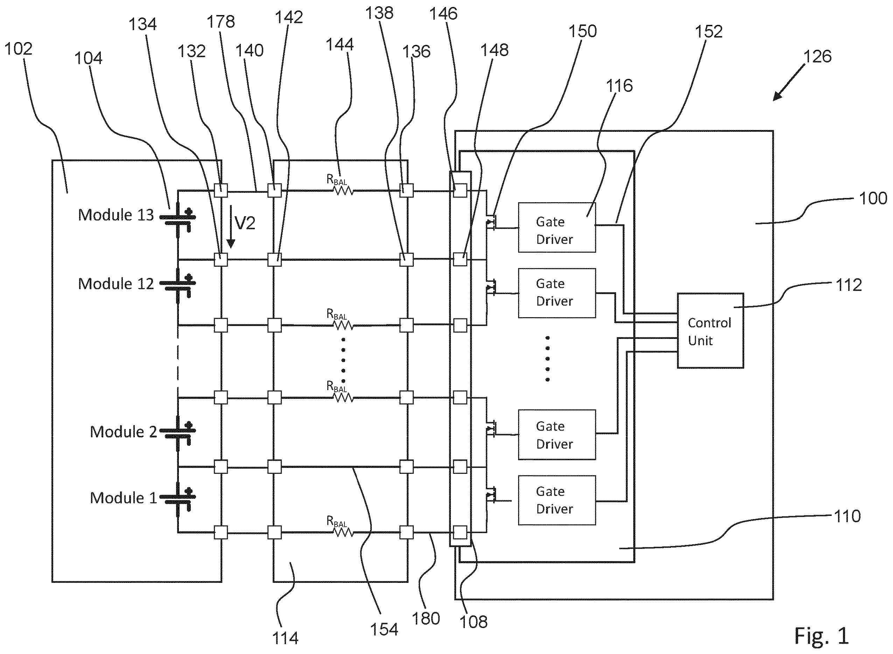

Figure 1 schematically illustrates an embodiment of the device 100 and/or system 126. In addition, Figure 1 shows a schematic illustration of a resistor unit 114 and a schematic illustration of a battery pack 102. Before discussing the device 100, an example of the battery pack 102 is explained.

The battery pack 102 shown schematically in Figure 1 illustrates a possible embodiment of a plurality of possible embodiments for the battery pack 102. The battery pack 102 is therefore not intended to be limited to the embodiment shown schematically in Figure 1. Nevertheless, Figure 1 is suitable for explaining the basic structure of the battery pack 102.

The battery pack 102 includes a plurality of battery modules 104 connected in series. The battery pack 102 may also be referred to and/or understood as a battery. In the embodiment of the battery pack 102 shown in Figure 1, the battery pack 102 includes thirteen battery modules 104. The battery modules 104 may also be briefly referred to as modules 104, for example module 1 to module 13 in Figure 1. Each battery module 104 may be understood as a device or unit of the battery pack 102. Each battery module 104 includes at least one battery cell. For example, each battery cell may be formed as a lithium ion battery cell or a lithium iron phosphate battery cell. Other battery cells for the battery modules 104 are also possible.

The battery cells of a battery module 104 may be connected together in parallel and/or in series. For example, a battery module 104 may include a plurality of battery cells connected in series to form a string of battery cells. The battery module 104 may include a plurality of these strings connected in parallel. In principle, however, the battery cells of a battery module 104 may also be connected together in a different structure. Furthermore, in an embodiment, each battery module 104 may comprise only a single battery cell.

It may be desirable that the battery cells of the battery modules 104 of the battery pack 102 be identical. However, in practice, there may be slight variations in the amount of charge stored by the battery cells and in the electrical voltages delivered by the battery cells. After multiple charge and discharge cycles of the battery pack 102, there may be an increased differences in the amount of charge stored by the battery modules 104 and in the electrical voltages delivered by the battery modules 104. These differences may affect the performance of the battery pack 102 and the life of the battery pack 102.

Generally, methods are known to equalize the electrical voltages of battery modules 104 (and the amounts of charge stored) to compensate for the differences between the electrical voltages of the battery modules 104. This is also referred to as balancing a battery module 104 and/or its battery cells. In the known methods, a distinction is made between active balancing and passive balancing. In passive balancing of the battery modules 104, the battery modules 104 provided a too high electrical voltages are monitored and discharged to a certain degree so that a state of equilibrium is established with respect to the electrical voltages of the battery modules 104. Often, at least the battery modules 104 with the higher electrical voltage are discharged to the extent that their respective voltages are equal to a predetermined value. The aim is for all battery modules 104 to provide the same electrical voltage except for a predetermined (very) small deviation.

However, known methods for discharging a battery module 104 have the effect that a discharge current for discharging the battery module 104 becomes smaller the smaller a voltage difference between the actual module voltage V2 and a predetermined electric voltage that the module voltage V2 is to reach by discharging the battery module 104. This decreasing discharge current during the discharging process causes the discharging process to take a relatively long time until the actual module voltage V2 of a battery module 104 reaches the predetermined electrical voltage.

The device 100 according to the present disclosure is configured to accelerate the discharge process for battery modules 104, thereby reducing the time consumed during the discharge process. The device 100 offers the advantage that the discharge current does not have to drop during the discharge process, but that the discharge current can remain constant throughout the discharge process, or at least does not drop to a value that significantly increases the duration of the discharge process compared to a constant discharge current. Thus, it is possible by the device 100 that, for example, a maximum permissible constant discharge current is effected during the discharge process and the discharge current is terminated at the end of the discharge process. Battery modules 104 of a battery pack 102 can be discharged by the device 100 at a particularly high average discharge rate and/or in a particularly short discharge time, so that the module voltages V2 of the battery modules 104 each reach a predetermined voltage value.

The device 100 is coupled to the battery pack 102 via a resistive unit 114. The resistor unit 114 may be understood as device or unit comprising multiple resistors. The resistors may be formed by ohmic resistors or impedances. An embodiment of the resistor unit 114 is shown schematically in Figure 1. The resistor unit 114 comprises resistor input terminals 136, 138 and resistor output terminals 140, 142. The resistor input terminals 136, 138 and resistor output terminals 140, 142 are preferably terminals for connecting electrical signal lines, respectively. Electrical resistors 144 and preferably direct signal lines 154 may be formed between the resistor input terminals 136, 138 and the resistor output terminals 140, 142. In the example resistor unit 114 of Figure 1, the first resistor input terminal 136 is electrically connected to the first output terminal 140 via a resistor 144. The resistor may also be referred to as a load resistor 144. The load resistor 144 may be formed as a ohmic electrical resistor or as an electrical impedance. The second resistor input terminal 138 of the resistor unit 114 is electrically connected to the second resistor output terminal 142 via a direct line 154. The direct line 154 may be provided, for example, as an electrical short between the second resistor input terminal 138 and the second resistor output terminal 142. As can be taken schematically from Figure 1, the resistor input terminals 136, 138 and the resistor output terminals 140, 142 may be alternately connected by a load resistor 144 and a direct line 154.

Preferably, the battery pack 102 includes a plurality of module terminals 132, 134. Preferably, each of the module terminals 132, 134 is a terminal for connecting an electrical signal line. In the example battery pack 102 of Figure 1, each battery module 104 is electrically connected to two associated module terminals 132, 134. For example, a first electrical pole of the thirteenth battery module 104 may be connected to the first module terminal 132 and a second electrical pole of the thirteenth battery module 104 may be connected to the second module terminal 134. The first pole may be a positive pole (plus pole) and the second pole may be a negative pole (minus pole). Therefore, the module voltage V2 of the thirteenth battery module 104 is provided between the first module terminal 132 and the second module terminal 134. The preceding explanations apply in an analogous manner to the other battery modules 104 of the battery pack 102. In addition, it can be taken from the example battery pack 102 of Figure 1 that the battery modules 104 are connected in series. Therefore, the second module terminal 134 of the thirteenth battery module 104 may form a first module terminal of the twelfth battery module 104. A second module terminal of the twelfth battery module may in turn form a first module terminal of the next battery module in the series connection of the battery modules 104. At each of the plurality of module terminals, the electrical potential existing at the poles of the modules 104 of the battery pack 102 may be detected.

To couple the battery pack 102 to the resistor unit 114, a plurality of electrical connection signal lines 178 may be provided to electrically connect the resistor output terminals 140, 142 of the resistor unit 114 to the module terminals 132, 134. For example, one of the connection lines 178 may connect the first resistor output terminal 140 to the first module terminal 132. Another of the connection lines 178 may connect the second resistor output terminal 142 to the second module terminal 134. The same may apply to the further resistor output terminals and the further module terminals.

Figure 1 also schematically illustrates an embodiment of the device 100. The device 100 is used to controlling the charge of a battery pack 102 comprising a plurality of battery modules 104 connected in series, each comprising at least one battery cell. The device 100 includes a driver interface 108. The driver interface 108 is used to couple the device 100 to the resistor unit 114. Further, the device 100 comprises a driver unit 110 coupled to the driver interface 108. The driver interface 108 may be understood as an interface, in particular a signal interface, that forms a part of the driver unit 110.

The driver interface 108 is configured to be connectable to the battery pack 104 via the resistor unit 114. The driver unit 110 includes a plurality of drivers 116. The driver unit 110 is a unit or part of the device 100 and is referred to as the driver unit. Each driver 116 may be configured as a driver circuit or comprise a driver circuit. Each driver 116 may be understood as an electronic sub-unit of the driver unit 110.

Each driver 116 is configured to regulate, in particular to control the electrical charge of a battery module 104 according to a pulse width modulated (PWM) control signal. In particular, each driver 116 may be configured to regulate, in particular to control the electrical charge of one of the battery modules 104 of the battery pack 102 according to a pulse width modulated (PWM) control signal. The device 100 further includes a control unit 112. The control unit 112 is coupled to each of the drivers 116. The control unit 112 is configured to generate an associated PWM control signal for each driver 116 for individually controlling the respective driver 116. Further, the control unit 112 is configured to transmit to each driver 116 the associated PWM control signal such that electrical charge of the battery modules 104 is individually controllable by the control unit 112 via the PWM control signals.

As previously explained, each driver 116 is configured to control the electrical charge of a battery module 104 in accordance with a PWM control signal. In an example, one of the drivers 116, preferably the driver 116 of the driver unit 110 shown in Figure 1 at the top, is coupled to the first module terminal 132 and the second module terminal 134 via the resistor unit 114 so that the driver 116 can cause a closed circuit comprising the thirteenth battery module 104 and the load resistor 144, for example, by closing the switch 150. A discharge current in the closed circuit is determined by the module voltage V2 provided by the thirteenth battery module 104 and the resistance of the load resistor 144, assuming that a switching resistance of the switch 150 and resistances of the electrical connection lines are negligible. The driver 116 may further cause the circuit to open, for example, by opening the switch 150. The driver 116 is preferably further configured to open and close the switch 150 in accordance with the PWM control signal. In an example, the control unit 112 may comprise at least one associated switch 150 for each driver 116.

The PWM control signal is a periodic signal having a preferably constant period duration. Each period duration of a period of the PWM control signal may be divided into a turn-on-time, while the PWM control signal has a first value, and a turn-off-time, while the PWM control signal has a second value. The first and second value are different. The ratio between the turn-on-time and the period of the PWM control signal is preferably referred to as the duty cycle. In the turn-on-time, the PWM control signal may have a non-zero voltage as a first value. In the turn-off-time, the PWM control signal may have about 0 V as a second value. The driver 116 may be configured to have the circuit closed during the turn-on-time and open during the turn-off-time. The larger the turn-on-time or duty cycle, the longer is the circuit closed by the driver 116 and/or its associated switch 150. The average discharge current may be understood to be the discharge current averaged over time over at least one period of the PWM control signal. By increasing the turn-on-time or the duty cycle, the average discharge current can be increased. By decreasing the turn-on-time or duty cycle, the average discharge current can be decreased. Furthermore, it is possible with the driver 116 to effect a constant average discharge current. For example, if the thirteenth battery module 104 is discharged under control of a PWM control signal by means of the uppermost driver 116, the module voltage V2 provided by the thirteenth battery module 104 decreases. If the turn-on-time or duty cycle of the PWM control signal for the driver 116 would be maintained changed during the discharge process, the average discharge current would decrease. To counteract this effect, the turn-on-time or duty cycle of the PWM control signal for the driver 116 of the apparatus 100 of the present disclosure may be increased during the discharge process of the thirteenth battery module 104 so that a constant average discharge current over time is achievable despite the decreasing module voltage V2. The control unit 112 of the apparatus 100 of the present disclosure may be configured to adjust the PWM control signal accordingly.

The driver unit 110 includes a plurality of drivers 116. Each driver 116 may individually control a charge and/or module voltage V2 of one of the battery modules 104 of the plurality of battery modules 104 of the battery pack 102. Each driver 116 may be configured to receive a PWM control signal. Since the control unit 112 is configured to generate a separate PWM control signal for each driver 116 to individually control the respective driver 116, it is possible by the control unit 112 to individually control the electrical charge of the battery modules 104 by the control unit 112 via the PWM control signals. For example, the control unit 112 may control each individual driver 116 via a respective associated PWM control signal such that each driver 116 controls, preferably discharges, the electrical charge of a battery module 104 coupled to the driver 116 via the resistor unit 114 at a constant average discharge current. The average discharge current may be understood to be constant over time. The control unit 112 may be configured to terminate the discharge process for each battery module 104 individually when the module voltage V2 of the respective battery module 104 reaches a desired voltage. The desired voltage may be a predetermined voltage and/or may be referred to as a reference voltage. The control unit 112 may be configured to receive a signal representing the reference voltage. This signal may also be referred to as a reference signal.

A constant average discharge current has the advantage that a time required for the discharge process until the actual module voltage V2 of a battery module 104 reaches the desired voltage is reduced. Therefore, a balancing of the battery modules 104 of a battery pack 102 can take place in a particularly short period of time.

An electrical charge of a battery module 104 may preferably refer to an amount of electrical charge stored by the respective battery module 104.

Preferably, regulating or controlling an electrical charge of a battery module 104 may also be understood to include a controlled reducing the electrical charge of the respective battery module 104 and/or controlled discharging of the battery module 104.

Each driver 116 may include an electrical circuit or may be formed by the electrical circuit. Each driver 116 may comprise at least one switch 150 associated therewith. The driver interface 108 may include a plurality of driver terminals 146, 148. The at least one switch 150 associated with a driver 116 may be coupled to two driver terminals 146, 148 of the driver interface 108 such that the driver terminals 146, 148 may be electrically connected or electrically disconnected via the at least one switch 150. The at least one switch 150 may be opened and closed by the associated driver 116 in accordance with a PWM control signal receivable by the driver 116. Thus, the at least one switch 150 may be closed during a turn-on-time of the PWM control signal by the driver 116 and opened during a turn-off-time of the PWM control signal by the driver 116.

A plurality of electrical connection lines 180 may be provided to couple the driver interface 108 to the resistor unit 114. For example, the first driver terminal 146 of the driver interface 108 may be electrically connected to the first resistor input terminal 136 via an electrical connection line 180. A second driver terminal 148 of the driver circuit 108 may be electrically connected to the second resistor input terminal 138 via another electrical connection line 180. The at least one switch 150 may therefore be used, for example, to open or close a circuit that includes the at least one switch 150, the thirteenth battery module 104, and a load resistor 144 of the resistor module 114. A corresponding embodiment may be provided for each of the other drivers 116 and battery modules 104. For example, each driver 116 may be associated with another one of the battery modules 104.

The device 100 may be configured as a single device 100 that is separate or separable from the resistor module 114 and/or other parts of the system 126. However, it is also possible for the device 100 to form part of a system 126.

In an example, the system 126 may comprise the device 100, the resistive module 114 and the electrical connection lines 180. In another example, the system 126 may further comprise the battery pack 102 and the electrical connection signal lines 178. When preferred features, technical effects and/or advantages of the device 100 are explained in preceding sections or in subsequent sections, such explanations are intended to refer both to an embodiment of device 100 being a part of the system 126 and/or to another embodiment of the device 100 as such, i.e., without being part of the system 126.

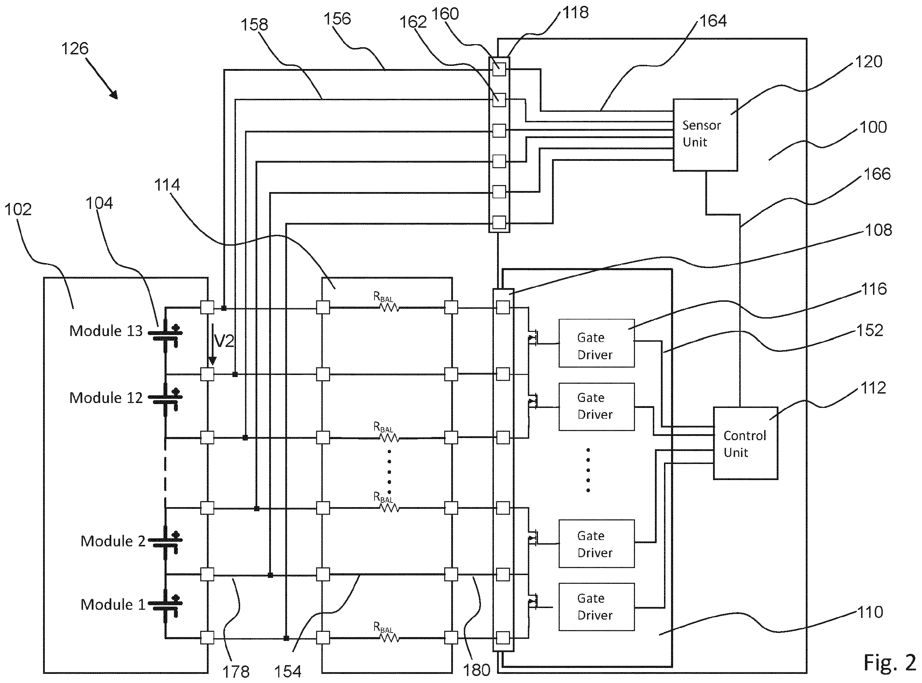

Another embodiment of the device 100 is shown schematically in Figure 2. Although the device 100 is shown in Figure 2 as a part of a system 126, the explanations of the device 100 shall apply in an analogous manner - as indicated above - when the device 100 may be formed separated from the other parts and components of the system 126.

The system 126 includes a battery pack 102 and a resistor unit 114 coupled via electrical connection lines 178. The system 126 also includes the device 100, which comprises the control unit 112 and the driver unit 110. The resistor unit 114 and the driver unit 110 of the device 100 are coupled via electrical connection lines 180. The driver unit 110 comprises the driver interface 108 for this purpose. With respect to the driver unit 110 of the device 100, reference is made to the preceding explanations of the device 100 of Figure 1 in an analogous manner. Also for the resistor unit 114 and the battery pack 102, reference is made to the preceding explanations of Figure 1 in an analogous manner.

Compared to the device 100 of Figure 1, the device 100 of Figure 2 further comprises a sensor interface 118 and a sensor unit 120. The sensor interface 118 may preferably be understood as an interface, in particular a signal interface, which is referred to as a sensor interface because it is connected to the sensor unit 120. The sensor interface 118 may comprise a plurality of sensor terminals 160, 162. Each of the sensor terminals 160, 162 can preferably be understood as a terminal to which an electrical line, in particular sensor connection lines 158, 156, can be connected. For example, a first sensor terminal 160 may be connected to the first module terminal 132 via the electrical sensor connection line 156 and the second sensor terminal 162 may be connected to the second module terminal 134 via the electrical sensor connection line 158. Each sensor connection line 156, 158 may be understood as an electrical line. The sensor interface 118, and in particular the associated sensor terminals 160, 162 may be connected to the sensor unit 120 via sensor signal lines 164. The sensor signal lines 164 may also be electrical lines.

The sensor unit 120 is configured to detect module voltages V2 of the battery modules 104 based on signals from the battery pack 102 representing electrical potentials at the battery pack 102. For example, the sensor unit 120 may detect the module voltages V2 via the sensor lines 164, the sensor interface 118, the first and second sensor connection lines 156, 158, and the first and second module terminals 132, 134. The 13th battery module 104 generates an electrical potential at each of the associated poles such that the module voltage V2 is provided between the two terminals 132, 134 of the 13th battery module 104. Due to the plurality of sensor terminals 160, 162, it is possible for each module terminal 132, 134 to be electrically connected to one of the sensor terminals 160, 162 via an associated connection line 156, 158 so that each module voltage V2 from each of the battery modules 104 is detectable by means of the sensor unit 120. The sensor unit 120 is coupled to the control unit 112 via the signal line 166. The sensor unit 120 may be configured to generate a sensor signal representing the module voltages V2 detected by the sensor unit 120. The sensor unit 120 may further be configured to transmit the sensor signal to the control unit 112 via the signal line 166. This may allow the control unit 112 to have the information about the module voltages V2 of the battery modules 104.

The control unit 112 may be configured to generate for each driver 116 the associated PWM control signals based on the module voltage V2 of the respective battery module 104. For example, the control unit 112 may be configured to generate, for the driver 116 connected to the 13th battery module 104 via the driver interface 108 and the resistor unit 114, the PWM control signal associated with that driver 116 based on the module voltage V2 of the 13th battery module 104. In an example, only a single dedicated driver 116 is preferably provided for each battery module 104, such that the control unit 112 is preferably configured to generate for each driver 116 the associated PWM control signal based on the module voltage V2 of the associated battery module 104. Thus, rather than generating a single PWM control signal, the control unit 112 may be configured to generate for each driver 116 an associated PWM control signal. The PWM control signal may change depending on the module voltage V2 of the respective battery module 104. The individual control of the drivers 116 via the different PWM control signals of the control unit 112 may provide the advantage that the electrical charge of each battery module 104 can be brought to a desired charge level in a particularly short time and/or in order to achieve a particularly fast balancing. The detection of the module voltages V2 via the sensor unit 120 and the connection between the sensor unit 120 and the control unit 112 also offer the advantage that a closed loop control can be created which allows to control the module voltages V2 and/or charge of the battery modules 104 quickly and precisely to a predetermined level.

In one or more embodiments of the device 100, each driver 116 is configured to change between an active state and a deactivated state according to the PWM control signal for the respective driver 116. In an example, the driver 116 may be configured to close the at least one associated switch 150 in the active state. By closing the at least one switch 150, the driver 116 may close a circuit that comprises the at least one switch 150. In an example, this circuit may also be referred to as a discharge circuit. In an example, the driver 116 may be configured to not close the at least one associated switch 150 in the passive state. Rather, the at least one switch 150 remains open in the passive state of the driver 116. Further, in an example of the device 100, each driver 116 may be configured to reduce the charge of a battery module 104 in the active state and leave the charge of the battery module 104 unchanged in the deactivated state. Preferably, each driver may be configured to receive a PWM control signal in both the passive state and the active state. By changing from a passive state to an active state of a driver 116, it may be possible for a charge of a battery module 104 (indirectly) coupled to the respective driver 116 to be controllable. In an example, the charge of a battery module 104 may remain unchanged when the driver 116 (indirectly) coupled to the battery module 104 is in a passive state. In an example, the charge of a battery module 104 may be reduced when the driver 116 (indirectly) coupled to the battery module 104 is in the active state.

In one or more embodiments of the device 100, each driver 116 is configured to change between the active state and the deactivated state depending on an turn-on-time, an turn-off-time, and/or a duty cycle of the PWM control signal for the respective driver 116. Preferably, each period of a PWM control signal is divided into an turn-on-time and an turn-off-time. Preferably, the turn-on-time is a minimum of zero seconds and a maximum of the entire period of the respective period of the PWM control signal. Preferably, the switch-off time is a minimum of zero seconds and a maximum of the entire period of the respective period of the PWM control signal. Preferably, the time of the turn-off time depends on the duration of the turn-on time, or vice versa. In an example, each driver 116 is configured to change to the active state during each turn-on-time of a received PWM control signal and to the passive state during each turn-off-time of the received PWM control signal. Therefore, a turn-on time, a turn-off time, and/or a duty cycle of the PWM control signal for the respective driver 116 may be used to control, in an example, the duration of the active state or the duration of the passive state of the respective driver 116 and, as a result, the average discharge current of a battery module 104 (indirectly) coupled to the respective driver 116.

In one or more embodiments of the device 100, the control unit 112 is configured to determine the drivers 116 to be activated based on the detected module voltages V2 of the battery modules 104. As previously discussed, the control unit 112 is preferably connected to the sensor unit 120 via the signal line 166 such that a sensor signal can be transmitted from the sensor unit 120 to the control unit 112. The sensor signal may represent the module voltages V2 of the battery modules 104 detected by the sensor unit 120. Based on the module voltages V2, in an example, the control unit 112 may determine individually for each driver 116 whether to enable the respective driver 116. In another example, the control unit 112 may be configured to determine the turn-on-time and/or duty cycle of a PWM control signal for a driver 116 to be activated and transmit the appropriately adjusted PWM control signal to the respective driver 116. If the module voltage V2 of a battery module 104 deviates only slightly from a desired voltage for the battery module 104, the control unit 112 may determine a relatively large turn-on time with respect to the period of the PWM control signal to achieve a relatively high average discharge current despite the small voltage deviation. As a result, the module voltage V2 of the battery module 104 reaches the desired voltage particularly quickly. On the other hand, if relatively large difference between the module voltage V2 of a battery module 104 and a desired voltage for the battery module 104 is provide, the control unit 112 may determine a relatively small turn-on time with respect to the period of the PWM control signal in order to achieve, for example, a similar high discharge current as in the preceding example. Thus, by adjusting the turn-on-time of the PWM control signal, it may be possible to achieve an approximately constant average discharge current throughout the discharge process of the battery module 104 until the desired charge level or voltage level for the module voltage V2 is reached. The desired voltage may be predetermined and/or referred to as a reference voltage.

In one or more embodiments of the device 100, the control unit 112 may therefore be configured to generate for each driver 116 to be activated the associated PWM control signal such that the driver 116 generates a predetermined average discharge current to reduce the electrical charge of the associated battery module 104. Preferably, the control unit 112 is configured to generate PWM control signals with non-zero turn-off-times only for the activated drivers 116 or for drivers 116 to be activated. As previously mentioned, the average discharge current preferably refers to a current averaged over time, preferably over at least one period of the PWM control signal.

In one or more embodiments of the device 100, the control unit 112 may be configured to update the detected module voltages V2 of the battery modules 104 continuously or by repeated sampling. In an example, the control unit 112 may be configured to control the average discharge current for a battery module 104, preferably caused by an activated driver 116, by continuously or repeatedly adjusting the PWM control signal based on the updated module voltage V2 of the battery module 104 such that the average discharge current is constant. Thus, for example, if one of the drivers 116 has been activated by a PWM control signal from the control unit 112 to reduce the charge of a battery module 104 (indirectly) coupled to the activated driver 116, the module voltage V2 of that battery module 104 may be detected by the sensor unit 120 and the detected module voltage V2 may be signaled as a sensor signal to the control unit 112. If the detection of the module voltage V2 is performed continuously or by repeated sampling, the control unit 112 may adjust the PWM control signal continuously or repeatedly, respectively, The control unit 112 may be configured to adjust the turn-on-time or duty cycle of the PWM control signal so that the average discharge current flowing through the battery module 104 is constant. The module voltage V2 of a battery module 104 may to decrease as its charge decreases, so the control unit 112 in response may increase the turn-on-time or duty cycle of the PWM control signal to enable the constant average discharge current.

In one or more embodiments of the device 100, the control unit 112 may be configured to control the average discharge current for a battery module 104 by continuously or repeatedly adjusting an turn-on-time, an turn-off-time, or a duty cycle of the PWM control signal based on the updated module voltage V2 of the battery module 104 so that the average discharge current is constant. A constant average discharge current provides the advantage that a balanced state of the battery modules 104 of the battery pack 102 can be achieved particularly quickly.

In one or more embodiments of the device 100, control data may be stored by the control unit 112. The control data may map module voltages to turn-on-times, turn-off-times, and/or duty cycles. Preferably, the control unit 112 is configured to use the control data for each generation of a PWM control signal. As previously discussed, the control unit 112 may be configured to control the PWM control signal based on the module voltage V2 of a battery module 104. The information about the module voltage V2 of a battery module 104 may be provided to the control unit 112 by the sensor unit 120. With the module voltage V2, the control unit 112 may read out an associated turn-on-time, an associated turn-off-time, and/or an associated duty cycle from the control data. The read out turn-on-time, the read out turn-off-time, and/or the read out duty cycle may be used by the control unit 112 to generate a PWM control signal. The PWM control signal can be generated by the control unit 112 in such a way that the current period of the PWM control signal has a turn-on-time corresponding to the read-out switch-on time, a switch-off-time corresponding to the read out switch-off time and/or a duty cycle corresponding to the read out duty cycle.

In one or more embodiments of the device 100, a predetermined mapping algorithm is stored by the control unit 112 that, when the mapping algorithm is executed by the control unit 112, maps the module voltages V2 to turn-on-times, turn-off-times, and/or duty cycles. The control unit 112 may be configured to execute the mapping algorithm. In an example, the control unit 112 is configured to execute the mapping algorithm for each generation of a PWM control signal. Thus, the control unit 112 may use the mapping algorithm instead of the control data to generate a PWM control signal. Reference is therefore made to the preceding explanations in an analogous manner.

The drivers 116 of the driver unit are grouped into a first group of drivers 116 and a second group of drivers 116. In an example, the control unit 112 is configured to generate the PWM control signals such that all PWM control signals are based on a common PWM cycle having a constant time duration for each period of the PWM cycle. In an example, the control unit 112 is configured to activate only the drivers 116 of the first group in a first part of each period and to activate only the drivers 116 of the second group in a second part of each period. Preferably, the first part of a period corresponds to a first half of the respective period. Preferably, the second part of a period corresponds to the second half of the respective period. A full period may thus be formed from the first and second parts. However, it is also possible for a full period to be divided into the first and second parts, which are of different lengths. Dividing the periods respectively into a first part and a second part, and taking into account the allocation of the first group of drivers 116 to the first part and the allocation of the second group of drivers 116 to the second part, offers the advantage that the drivers 116 can be activated in groups, for example either the first group of drivers 116 or the second group of drivers 116. In other words, in an example, the control unit 112 may be configured to control the drivers 116 in groups. This is particularly advantageous when an example of a resistor unit 114 is used such as that schematically shown in Figures 1 and 2.

If preferred features, technical effects and/or advantages of the device 100 are explained in preceding sections or in subsequent sections of the present disclosure, these explanations are intended to may refer both or either one of a device 100 of the system 126 and/or to a device 100 as such, i.e. without being a part of the system 126.

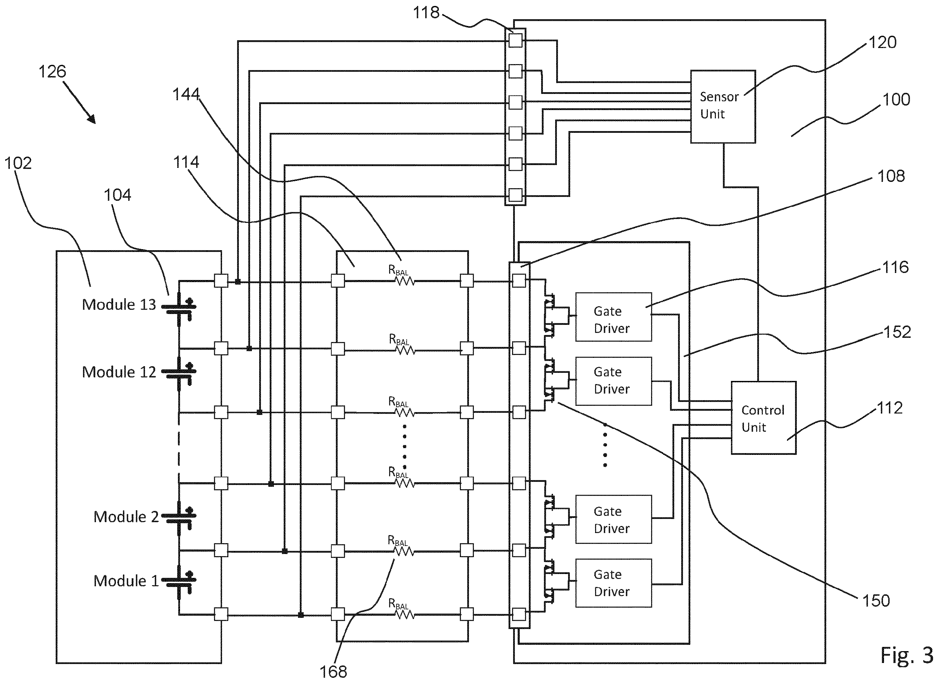

Figure 3 schematically illustrates another embodiment of a system 126 and/or device 100. The system 126 of Figure 3 may be substantially the same as the system 126 of Figure 2. However, the system 126 of Figure 3 differs in the resistor unit 114. Load resistors 168 are used instead of direct signal lines 154. The use of this resistor unit 114 has the advantage that all battery modules 104 may be discharged simultaneously by the device 100. The allocation of the driver unit 110 into the first and second groups can thus be omitted.

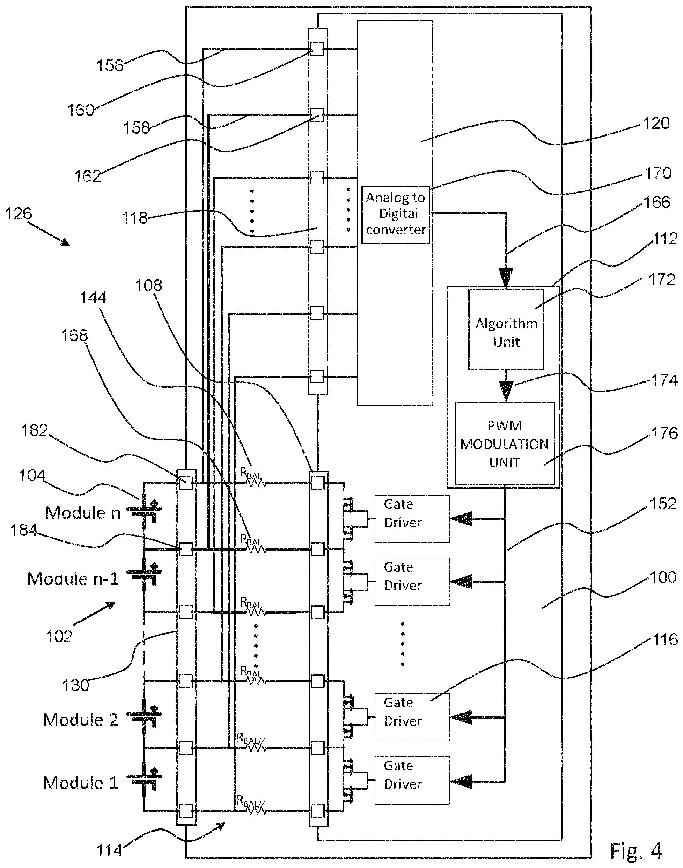

Figure 4 schematically illustrates another embodiment of the system 126. The system 126 comprises the device 100 and the resistor unit 114. With respect to the device 100 and the resistor unit 114, reference is made to the preceding explanations in an analogous manner. In an example, the resistive unit 114 and the device 100 form an integral and inseparable part of the system 126. The system 126 may also be formed as a device or apparatus.

The system 126 further comprises a system interface 130. The system interface 130 may be understood as an interface, in particular a signal interface, that is referred to as a system interface because it forms a part of the system 126.

The system interface 130 is connected to the driver interface 108 of the device 100 via the resistor unit 114, such that the resistors 144, 168 each form an electrical resistance between the driver interface 108 and the system interface 130. Preferably, the driver interface 108 and the device 100 are internal components of the system 126. In an example of this system 126, the driver interface 108 case is not intended and/or configured to be an interface for external access. Thus, a connection between the resistors 144, 168 and the driver interface 108 of the device 100 may be configured as a permanent and/or inseparable connection.

In an example, the sensor unit 120 of the device 100 may be configured as an analog to digital converter 170 or may comprise the analog to digital converter 170. As discussed in the preceding discussion, the device 100 may comprise a sensor interface 118 to detect the module voltages V2 of the battery modules 104. To this end, sensor terminals 160, 162 may be connected to terminals 182, 184 of system interface 130 via signal lines 156, 158. Therefore, the electrical potentials provided at the poles of the battery modules 104 can be directed to the sensor unit 120 via the system interface 130, the signal lines 156, 158 and the sensor interface 118, so that the associated analog-to-digital converter 170 can generate a sensor signal that is transmitted to the control unit 112 via the sensor line 166. Based on the sensor signal, the control unit 112 can generate a PWM control signal and direct it to the drivers 116 via the control lines 152.

In an example, the control unit 112 comprises a PWM modulator 176. The PWM modulator 176 may be configured to generate at least one PWM control signal, preferably a plurality of PWM control signals.

In an example, the control unit 112 comprises an algorithm unit 172. The algorithm unit 172 may be configured to execute the mapping algorithm stored by the control unit 112. By executing the mapping algorithm, module voltages V2 may be mapped to turn-on-times, turn-off-times, and/or duty cycles. Therefore, for each module voltage V2 detected by the sensor unit 120, the algorithm unit 172 may generate an associated control signal that is used to control the PWM modulator 172. For a plurality of battery modules 104, the algorithm unit 172 may therefore generate multiple control signals. These control signals may be bundled or individually transmitted to the PWM modulator 176 via the signal lines 174. The PWM modulator 176 may be configured to generate an associated PWM control signal based on each received control signal, and to direct this PWM control signal to the driver 116 that is (indirectly) connected to the battery module 104 whose battery voltage V2 resulted in the generation of the respective control signal.

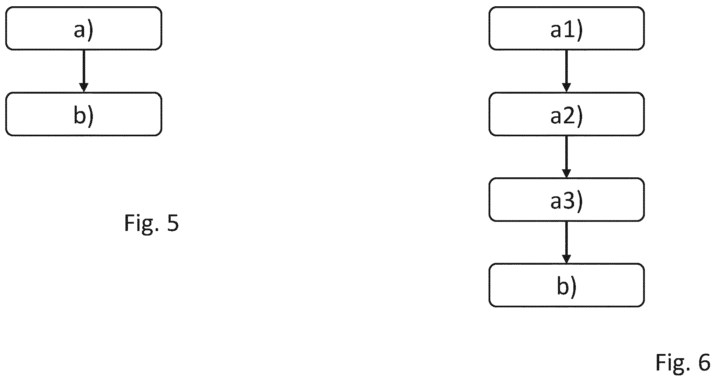

Figure 5 schematically illustrates an example of a flowchart of an embodiment of the method of the present disclosure. The method may be adapted for a device 100 for controlling the charge of a battery pack 102 comprising a plurality of battery modules 104 connected in series. With respect to the device 100, reference is made to the preceding explanations, technical effects and advances of the device 100 in an analogous manner. The method comprises the following steps a) and b):
a) Generating PWM control signals for drivers 114, preferably by the control unit 112,
b) Transmitting each PWM control signal generated for one of the drivers 116 from the control unit 112 to the respective driver 116, such that each driver 116 is individually controlled by the respective transmitted PWM control signal to control the electrical charge of the associated battery module 104.

In an example, instead of step a), the following steps a1) to a3) may be performed in the method. A correspondingly adapted example of a flow chart is shown schematically in Figure 6. In the example, the method may comprise the following steps:
a1) Detecting module voltages V2 of battery modules 104 by a sensor unit 120 based on signals from a battery pack 102 representing electrical potentials at the battery pack 102,
a2) Determining drivers 116 to be activated by the control unit 112 depending on the module voltages V2 of the battery modules 104,
a3) Generating for each driver 116 to be activated the associated PWM control signal by the control unit 120, such that the respective driver 116 generates a predetermined constant average discharge current for reducing the electrical charge of the associated battery module 104,
b) Transmitting each PWM control signal generated for one of the drivers 116 from the control unit 112 to the respective driver 116, such that each driver 116 is individually controlled by the respective transmitted PWM control signal to control the electrical charge of the associated battery module 104.

The apparatuses, systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware.

Unless stated otherwise, terms such as "first", "second", etc. are used to arbitrarily distinguish between the elements such terms describe. Thus, these terms are not necessarily intended to indicate temporal or other prioritization of such elements.

## Claims

1. An apparatus (100) for controlling a charge of a battery pack (102) having a plurality of battery modules (104) connected in series, each battery module including at least one battery cell, the apparatus comprising: a driver interface (108) for coupling with a resistor unit (114), a driver unit (110) connected to the driver interface, and a control unit (112), wherein the driver interface is configured to be connected to the battery pack via the resistor unit, wherein the driver unit comprises a plurality of drivers (116) each configured to regulate the electrical charge of a battery module according to a pulse width modulated, PWM, control signal, wherein the control unit is coupled to each driver, wherein the control unit is configured to generate for each driver an associated PWM control signal for individual control of the drivers, and wherein the control unit is configured to transmit to each driver the associated PWM control signal, so that an electrical charge of the battery modules can be controlled individually by the control unit via the PWM control signals, **characterized in that** the drivers of the driver unit are grouped into a first group of drivers and a second group of drivers, wherein the control unit is configured to generate the PWM control signals such that all control signals are based on a common PWM cycle having a constant time duration for each period of the PWM cycle, and wherein the control unit is configured to activate only the drivers of the first group in a first part of each period and to activate only the drivers of the second group in a second part of each period.

2. The apparatus according to the preceding claim, wherein the apparatus additionally comprises: a sensor interface (118) for coupling with the battery pack, and a sensor unit (120) connected to the sensor interface, wherein the sensor unit is configured to detect module voltages of the battery modules based on signals of the battery pack representing electrical potentials at the battery pack, wherein the control unit is configured to generate for each driver the associated PWM control signal based on the module voltage of the respective battery module.

3. The apparatus of any one of the preceding claims, wherein each driver is configured to change between an active state and a deactivated state according to the PWM control signal for the respective driver, wherein each driver is configured to reduce the charge of a battery module in the active state and to leave the charge of the battery module unchanged in the deactivated state.

4. The apparatus according to the preceding claim, wherein each driver is configured to change between the active state and the deactivated state in accordance with a turn-on time, a turn-off time or a duty cycle of the PWM control signal for the respective driver.

5. The apparatus according to any one of the preceding claims 3 to 4, when depending on claim 2, wherein the control unit is configured to determine drivers to be activated based on the detected module voltages of the battery modules.

6. The apparatus according to the preceding claim, wherein the control unit is configured to generate for each driver to be activated the associated PWM control signal such that the driver generates a predetermined average discharge current for reducing the electrical charge of the associated battery module.

7. The apparatus according to the preceding claim, wherein the sensor unit is configured to update the detected module voltages of the battery modules continuously or by repeated sampling, and wherein the control unit is configured to control the average discharge current for a battery module by continuous or repeated adjustment of the PWM control signal based on the updated module voltage of the battery module such that the average discharge current is constant.

8. The apparatus according to the preceding claim when in dependence on claim 4, wherein the control unit is configured to control the average discharge current for a battery module by continuous or repeated adjustment of a turn-on time, a turn-off time, or a duty cycle of the PWM control signal based on the updated module voltage of the battery module such that the average discharge current is constant.

9. The apparatus according to any one of the preceding claims, wherein the control unit is configured to store control data which maps module voltages to turn-on times, turn-off times and/or duty cycles, and wherein the control unit is configured to also use the control data for each generation of a PWM control signal.

10. The apparatus according to any one of the preceding claims, wherein the control unit is configured to store a predetermined mapping algorithm which, when executed by the control unit, maps module voltages to turn-on times, turn-off times and/or duty cycles, and wherein the control unit is configured to also execute the mapping algorithm for each generation of a PWM control signal.

11. A system for controlling the charge of a battery pack having a plurality of battery modules connected in series, each battery module including at least one battery cell, the system comprising: an apparatus according to any one of the preceding claims, a resistor unit with several electrical load resistors, and a system interface for coupling with the battery pack, wherein the system interface is electrically connected to the driver interface of the apparatus via the resistor unit, such that the load resistors each provide electrical resistance between the driver interface and the system interface.

12. The system according to the preceding claim, when depending on claim 2, wherein the sensor interface is connected to or formed by the system interface.

13. A method for an apparatus for controlling the charge of a battery pack comprising a plurality of battery modules connected in series, each battery module comprising at least one battery cell, the apparatus comprising a driver interface for coupling to a resistor unit, a driver unit connected to the driver interface, and a control unit, the driver interface being connectable to the battery pack via the resistor unit, wherein the driver unit comprises a plurality of drivers each configured to regulate the electrical charge of a battery module according to a pulse width modulated, PWM, control signal, the control unit being coupled to each driver for transmitting an associated PWM control signal, **characterized in that** the drivers of the driver unit are grouped into a first group of drivers and a second group of drivers, and wherein the method comprises the steps of:
a) Generate PWM control signals for the drivers by the control unit, such that all control signals are based on a common PWM cycle having a constant time duration for each period of the PWM cycle and such that only the drivers of the first group are activated in a first part of each period, and such that only the drivers of the second group are activated in a second part of each period;
b) Transmitting each PWM control signal generated for one of the drivers from the control unit to the respective driver so that each driver is individually controlled by the respective transmitted PWM control signal to regulate the electrical charge of the associated battery module.

14. The method according to the preceding claim, wherein the apparatus comprises a sensor interface for coupling to the battery pack and a sensor unit connected to the sensor interface, the method further comprising the following steps a1) to a3), which specify step a):
a1) Detecting of the module voltages of the battery modules by the sensor unit based on a signal from the battery pack representing electrical potentials at the battery pack,
a2) Determining the drivers to be activated by the control unit depending on the module voltages of the battery modules,
a3) Generating for each driver to be activated the associated PWM control signal by the control unit such that the respective driver generates a predetermined constant average discharge current for reducing the electrical charge of the associated battery module.

## Patentansprüche

1. Einrichtung (100) zum Steuern einer Ladung eines Batteriepacks (102) mit mehreren Batteriemodulen (104), die in Reihe geschaltet sind, wobei jedes Batteriemodul mindestens eine Batteriezelle beinhaltet, wobei die Einrichtung Folgendes umfasst: eine Treiberschnittstelle (108) zum Koppeln mit einer Widerstandseinheit (114), eine Treibereinheit (110), die mit der Treiberschnittstelle verbunden ist, und eine Steuereinheit (112),
wobei die Treiberschnittstelle dazu ausgelegt ist, über die Widerstandseinheit mit dem Batteriepack verbunden zu werden, wobei die Treibereinheit mehrere Treiber (116) umfasst, die jeweils dazu ausgelegt sind, die elektrische Ladung eines Batteriemoduls gemäß einem pulsbreitenmodulierten PWM-Steuersignal zu regeln, wobei die Steuereinheit mit jedem Treiber gekoppelt ist, wobei die Steuereinheit dazu ausgelegt ist, für jeden Treiber ein assoziiertes PWM-Steuersignal zur individuellen Steuerung der Treiber zu erzeugen, und wobei die Steuereinheit dazu ausgelegt ist, an jeden Treiber das assoziierte PWM-Steuersignal zu übertragen, so dass eine elektrische Ladung der Batteriemodule durch die Steuereinheit über die PWM-Steuersignale individuell gesteuert werden kann, **dadurch gekennzeichnet, dass**
die Treiber der Treibereinheit in eine erste Gruppe von Treibern und eine zweite Gruppe von Treibern gruppiert sind, wobei die Steuereinheit dazu ausgelegt ist, die PWM-Steuersignale so zu erzeugen, dass alle Steuersignale auf einem gemeinsamen PWM-Zyklus mit einer konstanten Zeitdauer für jede Periode des PWM-Zyklus basieren, und
wobei die Steuereinheit dazu ausgelegt ist, nur die Treiber der ersten Gruppe in einem ersten Teil jeder Periode zu aktivieren und nur die Treiber der zweiten Gruppe in einem zweiten Teil jeder Periode zu aktivieren.

2. Einrichtung nach dem vorhergehenden Anspruch, wobei die Einrichtung zusätzlich Folgendes umfasst: eine Sensorschnittstelle (118) zum Koppeln mit dem Batteriepack, und
eine Sensoreinheit (120), die mit der Sensorschnittstelle verbunden ist, wobei die Sensoreinheit dazu ausgelegt ist, Modulspannungen der Batteriemodule basierend auf Signalen des Batteriepacks zu detektieren, die elektrische Potentiale an dem Batteriepack repräsentieren, wobei die Steuereinheit dazu ausgelegt ist, für jeden Treiber das assoziierte PWM-Steuersignal basierend auf der Modulspannung des jeweiligen Batteriemoduls zu erzeugen.

3. Einrichtung nach einem der vorhergehenden Ansprüche, wobei jeder Treiber dazu ausgelegt ist, zwischen einem aktiven Zustand und einem deaktivierten Zustand gemäß dem PWM-Steuersignal für den jeweiligen Treiber zu wechseln, wobei jeder Treiber dazu ausgelegt ist, die Ladung eines Batteriemoduls in dem aktiven Zustand zu reduzieren und die Ladung des Batteriemoduls in dem deaktivierten Zustand unverändert zu lassen.

4. Einrichtung nach dem vorhergehenden Anspruch, wobei jeder Treiber dazu ausgelegt ist, zwischen dem aktiven Zustand und dem deaktivierten Zustand gemäß einer Einschaltzeit, einer Ausschaltzeit oder einem Tastverhältnis des PWM-Steuersignals für den jeweiligen Treiber zu wechseln.

5. Einrichtung nach einem der vorhergehenden Ansprüche 3 bis 4, wenn abhängig von Anspruch 2, wobei die Steuereinheit dazu ausgelegt ist, basierend auf den detektierten Modulspannungen der Batteriemodule zu aktivierende Treiber zu bestimmen.

6. Einrichtung nach dem vorhergehenden Anspruch, wobei die Steuereinheit dazu ausgelegt ist, für jeden zu aktivierenden Treiber das assoziierte PWM-Steuersignal zu erzeugen, so dass der Treiber einen vorbestimmten durchschnittlichen Entladestrom zum Reduzieren der elektrischen Ladung des assoziierten Batteriemoduls erzeugt.

7. Einrichtung nach dem vorhergehenden Anspruch, wobei die Sensoreinheit dazu ausgelegt ist, die detektierten Modulspannungen der Batteriemodule kontinuierlich oder durch wiederholtes Abtasten zu aktualisieren, und wobei die Steuereinheit dazu ausgelegt ist, den durchschnittlichen Entladestrom für ein Batteriemodul durch kontinuierliche oder wiederholte Anpassung des PWM-Steuersignals basierend auf der aktualisierten Modulspannung des Batteriemoduls so zu steuern, dass der durchschnittliche Entladestrom konstant ist.

8. Einrichtung nach dem vorhergehenden Anspruch, wenn abhängig von Anspruch 4, wobei die Steuereinheit dazu ausgelegt ist, den durchschnittlichen Entladestrom für ein Batteriemodul durch kontinuierliche oder wiederholte Anpassung einer Einschaltzeit, einer Ausschaltzeit oder eines Tastverhältnisses des PWM-Steuersignals basierend auf der aktualisierten Modulspannung des Batteriemoduls zu steuern, so dass der durchschnittliche Entladestrom konstant ist.

9. Einrichtung nach einem der vorhergehenden Ansprüche, wobei die Steuereinheit dazu ausgelegt ist, Steuerdaten zu speichern, die Modulspannungen auf Einschaltzeiten, Ausschaltzeiten und/oder Tastverhältnisse abbilden, und wobei die Steuereinheit dazu ausgelegt ist, auch die Steuerdaten für jede Erzeugung eines PWM-Steuersignals zu verwenden.

10. Einrichtung nach einem der vorhergehenden Ansprüche, wobei die Steuereinheit dazu ausgelegt ist, einen vorbestimmten Abbildungsalgorithmus zu speichern, der, wenn er durch die Steuereinheit ausgeführt wird, Modulspannungen auf Einschaltzeiten, Ausschaltzeiten und/oder Tastverhältnisse abbildet, und wobei die Steuereinheit dazu ausgelegt ist, auch den Abbildungsalgorithmus für jede Erzeugung eines PWM-Steuersignals auszuführen.

11. System zum Steuern der Ladung eines Batteriepacks mit mehreren in Reihe geschalteten Batteriemodulen, wobei jedes Batteriemodul mindestens eine Batteriezelle beinhaltet, wobei das System Folgendes umfasst: eine Einrichtung nach einem der vorhergehenden Ansprüche, eine Widerstandseinheit mit mehreren elektrischen Lastwiderständen und eine Systemschnittstelle zum Koppeln mit dem Batteriepack, wobei die Systemschnittstelle über die Widerstandseinheit elektrisch mit der Treiberschnittstelle der Einrichtung verbunden ist, so dass die Lastwiderstände jeweils einen elektrischen Widerstand zwischen der Treiberschnittstelle und der Systemschnittstelle bereitstellen.

12. System nach dem vorhergehenden Anspruch, wenn abhängig von Anspruch 2, wobei die Sensorschnittstelle mit der Systemschnittstelle verbunden oder durch diese gebildet ist.

13. Verfahren für eine Einrichtung zum Steuern der Ladung eines Batteriepacks, das mehrere Batteriemodule umfasst, die in Reihe geschaltet sind, wobei jedes Batteriemodul mindestens eine Batteriezelle umfasst, wobei die Einrichtung eine Treiberschnittstelle zum Koppeln mit einer Widerstandseinheit, eine Treibereinheit, die mit der Treiberschnittstelle verbunden ist, umfasst, und eine Steuereinheit, wobei die Treiberschnittstelle über die Widerstandseinheit mit dem Batteriepack verbindbar ist, wobei die Treibereinheit mehrere Treiber umfasst, die jeweils dazu ausgelegt sind, die elektrische Ladung eines Batteriemoduls gemäß einem pulsbreitenmodulierten PWM-Steuersignal zu regeln, wobei die Steuereinheit mit jedem Treiber zum Übertragen eines assoziierten PWM-Steuersignals gekoppelt ist, **dadurch gekennzeichnet, dass**
die Treiber der Treibereinheit in eine erste Gruppe von Treibern und eine zweite Gruppe von Treibern gruppiert sind, und wobei das Verfahren die folgenden Schritte umfasst:
a) PWM-Steuersignalen für die Treiber durch die Steuereinheit zu erzeugen, so dass alle Steuersignale auf einem gemeinsamen PWM-Zyklus mit einer konstanten Zeitdauer für jede Periode des PWM-Zyklus basieren und so, dass nur die Treiber der ersten Gruppe in einem ersten Teil jeder Periode aktiviert werden, und so, dass nur die Treiber der zweiten Gruppe in einem zweiten Teil jeder Periode aktiviert werden;
b) Übertragen jedes PWM-Steuersignals, das für einen der Treiber erzeugt wird, von der Steuereinheit an den jeweiligen Treiber, so dass jeder Treiber individuell durch das jeweilige übertragene PWM-Steuersignal gesteuert wird, um die elektrische Ladung des assoziierten Batteriemoduls zu regeln.

14. Verfahren nach dem vorhergehenden Anspruch, wobei die Einrichtung eine Sensorschnittstelle zum Koppeln mit dem Batteriepack und eine Sensoreinheit, die mit der Sensorschnittstelle verbunden ist, umfasst, wobei das Verfahren ferner die folgenden Schritte a1) bis a3) umfasst, die den Schritt a) spezifizieren:
a1) Detektieren der Modulspannungen der Batteriemodule durch die Sensoreinheit basierend auf einem Signal von dem Batteriepack, das elektrische Potentiale an dem Batteriepack repräsentiert,
a2) Bestimmen der durch die Steuereinheit zu aktivierenden Treiber in Abhängigkeit von den Modulspannungen der Batteriemodule,
a3) Erzeugen, für jeden zu aktivierenden Treiber, des assoziierten PWM-Steuersignals durch die Steuereinheit,
so dass der jeweilige Treiber einen vorbestimmten konstanten durchschnittlichen Entladestrom zum Reduzieren der elektrischen Ladung des assoziierten Batteriemoduls erzeugt.

## Revendications

1. Appareil (100) de commande d'une charge d'un bloc-batterie (102) pourvu d'une pluralité de modules de batterie (104) connectés en série, chaque module de batterie comportant au moins une cellule de batterie, l'appareil comprenant : une interface de pilotes (108) destinée à être couplée à une unité de résistances (114), une unité de pilotes (110) connectée à l'interface de pilotes, et une unité de commande (112),
l'interface de pilotes étant configurée pour être connectée au bloc-batterie par l'intermédiaire de l'unité de résistances, l'unité de pilotes comprenant une pluralité de pilotes (116) configurés chacun pour réguler la charge électrique d'un module de batterie selon un signal de commande à modulation de largeur d'impulsion, PWM, l'unité de commande étant couplée à chaque pilote, l'unité de commande étant configurée pour générer, pour chaque pilote, un signal de commande PWM associé destiné à une commande individuelle des pilotes, et l'unité de commande étant configurée pour transmettre à chaque pilote le signal de commande PWM associé, de sorte qu'une charge électrique des modules de batterie puisse être commandée individuellement par l'unité de commande par l'intermédiaire des signaux de commande PWM, **caractérisé en ce que**
les pilotes de l'unité de pilotes sont groupés en un premier groupe de pilotes et un deuxième groupe de pilotes, l'unité de commande étant configurée pour générer les signaux de commande PWM de sorte que tous les signaux de commande soient basés sur un cycle PWM commun ayant une durée constante pour chaque période du cycle PWM, et l'unité de commande étant configurée pour activer seulement les pilotes du premier groupe dans une première partie de chaque période et pour activer seulement les pilotes du deuxième groupe dans une deuxième partie de chaque période.

2. Appareil selon la revendication précédente, l'appareil comprenant en outre : une interface de détection (118) destinée à être couplée au bloc-batterie, et
une unité de détection (120) connectée à l'interface de détection, l'unité de détection étant configurée pour détecter des tensions de module des modules de batterie sur la base de signaux du bloc-batterie représentant des potentiels électriques au niveau du bloc-batterie, l'unité de commande étant configurée pour générer, pour chaque pilote, le signal de commande PWM associé sur la base de la tension de module du module de batterie respectif.

3. Appareil selon l'une quelconque des revendications précédentes, dans lequel chaque pilote est configuré pour commuter entre un état actif et un état désactivé selon le signal de commande PWM pour le pilote respectif, chaque pilote étant configuré pour réduire la charge d'un module de batterie dans l'état actif et pour laisser la charge du module de batterie inchangée dans l'état désactivé.

4. Appareil selon la revendication précédente, dans lequel chaque pilote est configuré pour commuter entre l'état actif et l'état désactivé conformément à une durée de niveau actif, une durée de niveau inactif ou un rapport cyclique du signal de commande PWM pour le pilote respectif.

5. Appareil selon l'une quelconque des revendications précédentes 3 à 4, lorsqu'elle dépend de la revendication 2, dans lequel l'unité de commande est configurée pour déterminer des pilotes à activer sur la base des tensions de module détectées des modules de batterie.

6. Appareil selon la revendication précédente, dans lequel l'unité de commande est configurée pour générer, pour chaque pilote à activer, le signal de commande PWM associé de sorte que le pilote génère un courant de décharge moyen prédéterminé destiné à réduire la charge électrique du module de batterie associé.

7. Appareil selon la revendication précédente, dans lequel l'unité de détection est configurée pour mettre à jour les tensions de module détectées des modules de batterie de manière continue ou par échantillonnage répété, et dans lequel l'unité de commande est configurée pour commander le courant de décharge moyen pour un module de batterie par ajustement continu ou répété du signal de commande PWM sur la base de la tension de module mise à jour du module de batterie de sorte que le courant de décharge moyen soit constant.

8. Appareil selon la revendication précédente lorsqu'elle dépend de la revendication 4, dans lequel l'unité de commande est configurée pour commander le courant de décharge moyen pour un module de batterie par ajustement continu ou répété d'une durée de niveau actif, d'une durée de niveau inactif ou d'un rapport cyclique du signal de commande PWM sur la base de la tension de module mise à jour du module de batterie de sorte que le courant de décharge moyen soit constant.

9. Appareil selon l'une quelconque des revendications précédentes, dans lequel l'unité de commande est configurée pour stocker des données de commande qui mettent en correspondance des tensions de module avec des durées de niveau actif, des durées de niveau inactif et/ou des rapports cycliques, et dans lequel l'unité de commande est configurée pour utiliser également les données de commande pour chaque génération d'un signal de commande PWM.

10. Appareil selon l'une quelconque des revendications précédentes, dans lequel l'unité de commande est configurée pour stocker un algorithme de mise en correspondance prédéterminé qui, lorsqu'il est exécuté par l'unité de commande, met en correspondance des tensions de module avec des durées de niveau actif, des durées de niveau inactif et/ou des rapports cycliques, et dans lequel l'unité de commande est configurée pour exécuter également l'algorithme de mise en correspondance pour chaque génération d'un signal de commande PWM.

11. Système de commande de la charge d'un bloc-batterie pourvu d'une pluralité de modules de batterie connectés en série, chaque module de batterie comportant au moins une cellule de batterie, le système comprenant : un appareil selon l'une quelconque des revendications précédentes, une unité de résistances avec plusieurs résistances de charge électrique, et une interface de système destinée à être couplée au bloc-batterie, l'interface de système étant connectée électriquement à l'interface de pilotes de l'appareil par l'intermédiaire de l'unité de résistances, de sorte que les résistances de charge fournissent chacune une résistance électrique entre l'interface de pilotes et l'interface de système.

12. Système selon la revendication précédente, lorsqu'elle dépend de la revendication 2, dans lequel l'interface de détection est connectée à l'interface de système ou est formée par celle-ci.

13. Procédé pour un appareil de commande de la charge d'un bloc-batterie comprenant une pluralité de modules de batterie connectés en série, chaque module de batterie comprenant au moins une cellule de batterie, l'appareil comprenant une interface de pilotes destinée à être couplée à une unité de résistances, une unité de pilotes connectée à l'interface de pilotes, et une unité de commande, l'interface de pilotes pouvant être connectée au bloc-batterie par l'intermédiaire de l'unité de résistances, l'unité de pilotes comprenant une pluralité de pilotes configurés chacun pour réguler la charge électrique d'un module de batterie selon un signal de commande à modulation de largeur d'impulsion, PWM, l'unité de commande étant couplée à chaque pilote afin de transmettre un signal de commande PWM associé, **caractérisé en ce que**
les pilotes de l'unité de pilotes sont groupés en un premier groupe de pilotes et un deuxième groupe de pilotes, et le procédé comprenant les étapes suivantes :
a) génération, par l'unité de commande, de signaux de commande PWM pour les pilotes, de sorte que tous les signaux de commande soient basés sur un cycle PWM commun ayant une durée constante pour chaque période du cycle PWM, et de sorte que seuls les pilotes du premier groupe soient activés dans une première partie de chaque période et que seuls les pilotes du deuxième groupe soient activés dans une deuxième partie de chaque période ;
b) transmission, de l'unité de commande au pilote respectif, de chaque signal de commande PWM généré pour l'un des pilotes de sorte que chaque pilote soit commandé individuellement par le signal de commande PWM respectif transmis afin de réguler la charge électrique du module de batterie associé.

14. Procédé selon la revendication précédente, dans lequel l'appareil comprend une interface de détection destinée à être couplée au bloc-batterie et une unité de détection connectée à l'interface de détection, le procédé comprenant en outre les étapes a1) à a3) suivantes, qui définissent plus précisément l'étape a) :
a1) détection, par l'unité de détection, des tensions de module des modules de batterie sur la base d'un signal provenant du bloc-batterie représentant des potentiels électriques au niveau du bloc-batterie,
a2) détermination des pilotes à activer par l'unité de commande en fonction des tensions de module des modules de batterie,
a3) génération, par l'unité de commande, pour chaque pilote à activer, du signal de commande PWM associé de sorte que le pilote respectif génère un courant de décharge moyen constant prédéterminé destiné à réduire la charge électrique du module de batterie associé.
